# EUROPÄISCHE PATENTANMELDUNG

(11) **EP 4 421 869 A1**
(43) Veröffentlichungstag der Anmeldung: **28.08.2024**
(21) Anmeldenummer: 23158836.9
(22) Anmeldetag: 27.02.2023
(51) Int. Cl.: H01L 25/10, H01L 23/498, H01L 23/538, H01L 25/065

(54) **DREIDIMENSIONAL-INTEGRIERTES MULTI-IC SYSTEM MIT INTERCONNECTBAUSTEINEN**

(71) Anmelder: Fraunhofer-Gesellschaft zur Förderung der angewandten Forschung e.V., 80686 München (DE)
(72) Erfinder: LANDESBERGER,Christof, 80686 München (DE)
(74) Vertreter: Hersina, Günter

(57) **Zusammenfassung**

Das hierin offenbarte erfindungsgemäße Konzept betrifft ein dreidimensional-integriertes Multi-IC System (100) mit einem Substratstapel (110), der mehrere vertikal übereinander gestapelte Substrate (111, 112, 113) aufweist, wobei jedes Substrat (111, 112, 113) jeweils eine Substratebene definiert. Auf den einzelnen Substraten (111, 112, 113) sind aktive IC-Bausteine (120) angeordnet, die in der jeweiligen Substratebene elektrisch untereinander verbunden sind. Erfindungsgemäß werden passive Interconnect-Bausteine (130) vorgeschlagen, die zwischen zwei benachbarten Substraten (111, 112, 113) angeordnet werden, wobei die Interconnect-Bausteine (130) jeweils vertikal verlaufende Signalleitungsstrukturen (131) aufweisen, die ausgestaltet sind, um eine elektrische Verbindung zwischen je zwei benachbarten Substraten (111, 112, 113) herzustellen.

## Beschreibung

Die vorliegende Erfindung liegt auf dem technischen Gebiet der Halbleitertechnik und betrifft ein dreidimensional-integriertes Multi-IC System (IC: Integrated Circuit / Integrierter Schaltkreis). Hierbei werden mehrere einzelne ICs sowohl lateral in einer Ebene, als auch vertikal über mehrere Ebenen hinweg, miteinander verbunden, wodurch sich der Integrationsgrad signifikant erhöhen lässt. Anwendungsbeispiele hierfür sind neuromorphe Chip-Architekturen, die sich mit der vorliegenden Erfindung realisieren lassen.

Prinzipiell ist man im Bereich der Halbleitertechnik bestrebt, die Integrationsdichte von integrierten Schaltungen - ICs - zu erhöhen, um die Performanz bzw. Rechenleistung zu steigern. Hierfür gibt es heutzutage verschiedene Ansätze.

Beispielsweise kann die Rechenleistung von Halbleiter-Prozessoren mittels einer Parallelisierung der Datenverarbeitung im Prozessor erheblich gesteigert werden. Bislang wurde dies durch die Einführung sogenannter Multi-Core-Prozessoren auf einem einzelnen IC-Baustein realisiert. Dabei werden mehrere Kerne lateral nebeneinander platziert. Noch mehr Rechenkerne (Cores) auf einem einzelnen IC zu integrieren, würde allerdings sehr großflächige Chips erfordern mit einer Fläche von mehreren Quadratzentimetern. Dies bedeutet jedoch ein erhebliches Ausschuss-Risiko für die volle Funktionalität der Bausteine sowie weiter steigende Anforderungen an die Wärmeableitung des großen Chips.

Ein bekannter Lösungsweg für die Integration von noch mehr Prozessorkernen sind Chiplet-Architekturen. Gemäß diesem Konzept werden mehrere kleinere ICs einzeln aufgebaut und dann möglichst eng und dicht miteinander elektrisch kontaktiert. Eine Herausforderung hierbei ist die Minimierung des Flächenbedarfs für die Kontaktstellen (I/O Pads) auf den einzelnen ICs. Dies erfordert u.a. eine sehr präzise Montagetechnologie für die einzelnen ICs auf einem Basis-Substrat im Bereich von 1 µm.

Eine weitere Parallelisierung von Rechenoperationen wird durch die Einführung von vertikal gestapelten Prozessoren ermöglicht, was auch als 3D-Integration bezeichnet wird. Dazu sind vertikale Kontakte zwischen einzelnen IC-Ebenen erforderlich. Grundsätzlich wäre es wünschenswert, die Weglänge von elektrischen Verbindungen zwischen den Prozessoren oder auch zwischen Prozessor- und Speicher-Bausteinen minimal zu halten. Dies ist eine wichtige Anforderung im Hinblick auf die Taktraten und den Leistungsbedarf solcher komplexer IC-Systeme.

Eine derartige Anordnung mehrerer einzelner ICs kann auch als Multi-IC System bezeichnet werden. Wenn viele einzelne Prozessoren mit sehr vielen Verbindungsleitungen untereinander auch in einer dreidimensionalen Anordnung miteinander kommunizieren können, so kann dies auch als neuromorphe Chip-Architektur bezeichnet werden.

Eine Schwierigkeit bei der 3D-Integration besteht darin, dass die zum Einsatz kommenden Bausteine nicht immer eine einheitliche Höhe aufweisen, da diese oftmals aus verschiedenen Halbleiterfertigungsbetrieben (Chip-Fabriken) angeliefert werden.

Zur Lösung dieses Problems wird im Stand der Technik vorgeschlagen, flexible Folienverbinder - sogenannte Interposer - zu verwenden. Diese Interposer werden wie eine Art Adapter zwischen zwei Chip-Ebenen angeordnet, um zwei ICs mit unterschiedlichen Pad-Konfigurationen miteinander zu verbinden und Höhenunterschiede auszugleichen.

Ein solcher Interposer ist beispielsweise in der US 2011 / 0 165 735 A1 beschrieben. Auf einem Substrat ist ein erster IC angeordnet. Vertikal darüber ist ein zweiter IC angeordnet. Zwischen den beiden ICs ist ein Interposer angeordnet. Der Interposer verbindet die beiden ICs elektrisch miteinander und stellt außerdem eine elektrische Verbindung zu Kontakten auf dem Substrat her. Zur Kontaktierung des Interposers mit dem Substrat verzichtet die US 2011 / 0 165 735 A1 explizit auf vertikal verlaufende lange, dünne Kontaktelemente, da diese als bruchgefährdet beschrieben werden. Stattdessen werden möglichst flache Kontaktpads verwendet, die jedoch deutlich flacher sind als der flachste IC auf dem jeweiligen Substrat. Um diesen Höhenunterschied auszugleichen, weist der viereckige Interposer an allen vier Außenseiten biegsame Flügel auf. Diese vier flexiblen Flügel werden nach unten gebogen, sodass der IC sozusagen eingehüllt wird. Das umgebogene Ende der Flügel wird dann mit den flachen Kontaktpads des Substrats verbunden. So wird der Höhenunterschied zwischen dem flachen Kontaktpad und dem höheren IC ausgeglichen.

Allerdings führt dieses "Einhüllen" des ICs dazu, dass sich Abwärme des ICs unter dem Interposer staut, was zur Überhitzung des ICs führen kann. Außerdem wird der Interposer beim Umbiegen der Flügel deformiert, und die Herstellung eines Interposers mit Flügeln ist insgesamt aufwändiger. Darüber hinaus ist die Anzahl der übereinander stapelbaren Ebenen sehr limitiert, denn aufgrund der begrenzten Größe der Flügel reichen diese, bei einem hohen vertikalen IC-Stapel, nicht über mehrere gestapelte Lagen bzw. Ebenen bis auf das Substrat hinunter. Zudem weisen die flachen, aber dafür breiten, Kontaktpads einen erhöhten Platzbedarf (in lateraler Richtung) auf, der meist nicht zur Verfügung steht.

Prinzipiell können also Höhenunterschiede zwischen unterschiedlich hohen ICs auf unterschiedlichen IC-Ebenen mit den zuvor beschriebenen flexiblen Folienverbindern bzw. Interposern ausgeglichen werden. Ein komplettes Substrat in Form einer Folie für eine komplette IC-Ebene zu nutzen bietet sich jedoch nicht an, da Folien immer das Risiko eines hohen geometrischen Verzugs aufweisen. Das heißt, Folien können sich aufgrund von mechanischen Spannungen bei der Montage derart verziehen, dass sich Leiterbahnen bzw. Kontaktierungsabschnitte auf der Folie verzerren, sodass die I/O Pads der ICs nicht mehr passgenau auf die dafür vorgesehenen Kontaktierungsabschnitte auf der Folie aufgesetzt werden können.

Somit wird der Abstand zwischen zwei entfernten Kontaktflächen für die Chip-Montage auf einer Folie in der Realität nicht dem Abstand der Kontaktflächen entsprechen, wie er im CAD-Design ursprünglich geometrisch definiert wurde. Solche Deformationen und unregelmäßigen Verzüge in einer Folie können über eine Distanz von 1 cm bis 5 cm durchaus 20 µm und mehr betragen. Anschlusspads von ICs können hingegen Abmessungen von lediglich 10 µm oder weniger aufweisen, sodass ein Verzug von 20 µm dazu führt, dass die 10 µm großen Pads nicht mehr passgenau auf der Folie positioniert werden können. Ein solcher Verzug der Folie würde demnach eine korrekte Justage der ICs von einer Ebene zur nächsten verhindern.

Daher wäre es wünschenswert, dreidimensional-integrierte Multi-IC Systeme dahingehend zu verbessern, dass den soeben beschriebenen Problemen Rechnung getragen wird.

Dieses Ziel wird erreicht mit einem dreidimensional-integrierten Multi-IC System gemäß Anspruch 1. Hierbei wird ein Substratstapel bereitgestellt, der mehrere vertikal übereinander gestapelte einzelne Substrate aufweist, wobei jedes Substrat jeweils eine Substratebene definiert. Auf den einzelnen Substraten sind jeweils ein oder mehrere aktive IC-Bausteine angeordnet, die in der jeweiligen Substratebene elektrisch untereinander verbunden sind. Das heißt, pro Substratebene sind die auf dem jeweiligen Substrat angeordneten ICs untereinander vernetzt. Dabei reicht es aus, wenn ein paar wenige, aber nicht zwangsläufig alle, ICs miteinander verschaltet sind. Dies entspräche einer horizontalen Verschaltung in der jeweiligen Substratebene. Erfindungsgemäß weist das hierin vorgestellte innovative dreidimensional-integrierte Multi-IC System ein oder mehrere passive Interconnect-Bausteine auf, die jeweils zwischen zwei benachbarten Substraten angeordnet werden. Die Interconnect-Bausteine weisen jeweils vertikal, d.h. senkrecht zur jeweiligen Substratebene, verlaufende Signalleitungsstrukturen auf. Diese vertikal verlaufenden Signalleitungsstrukturen sind ausgestaltet, um eine elektrische Verbindung zwischen je zwei (im Substratstapel) vertikal benachbarten Substraten herzustellen. Dadurch können die auf einem ersten Substrat montierten ICs mit den auf einem vertikal benachbarten zweiten Substrat montierten ICs verschaltet werden. Dies entspricht einer vertikalen Verschaltung zwischen unterschiedlichen Substratebenen, was dem Gedanken der 3D-Integration entspricht.

Aufgrund der immer weiter voranschreitenden Miniaturisierung bei gleichzeitiger Erhöhung der Integrationsdichte, müssen die Kontaktpads von aktiven IC-Bausteinen immer kleiner ausgeführt werden. Daher ist es wichtig, dass die kleinen Kontaktpads eines aktiven IC-Bausteins möglichst exakt auf entsprechenden Anschlusspads am Substrat platziert werden. Nur so kann eine vertikale Verbindung über mehrere Substratebenen hinweg sichergestellt werden. Dünne flexible Foliensubstrate, die sich bei der Montage mechanisch verformen bzw. verziehen sind daher als Substrat zunächst ungeeignet.

Die vorliegende Erfindung ermöglicht es jedoch, Foliensubstrate zu verwenden, da die vertikale Kontaktierung in den erfindungsgemäßen separaten Interconnect-Bausteinen erfolgt. Die erfindungsgemäßen Interconnect-Bausteine sind als massenfertigungstaugliche passive Bauelemente ausgestaltet. Sie können beispielsweise ausschließlich die vertikal verlaufenden Signalleitungsstrukturen aufweisen. Somit sind sie günstig und einfach herstellbar. Aufgrund ihrer Eigenschaft als passives Bauelement erzeugen sie außerdem deutlich weniger Wärme als aktive IC-Bausteine.

Aus all den vorgenannten Gründen können die erfindungsgemäßen Interconnect-Bausteine (in Relation zu ihrem Funktionsumfang) verhältnismäßig groß ausgestaltet sein, sodass auf den Ober- und Unterseiten der Interconnect-Bausteine viel Platz herrscht, um die elektrischen Kontaktpads unterzubringen. Dadurch können die elektrischen Kontaktpads deutlich größer dimensioniert werden als dies bei aktiven IC-Bausteinen möglich ist. Dies wiederum hat den Vorteil, dass auch ein großer Verzug eines Foliensubstrats bei dessen Montage in einem weiten Toleranzbereich ausgeglichen werden kann. Das heißt, selbst wenn sich das Foliensubstrat stark verzieht, können die Anschlusspads am Foliensubstrat immer noch passgenau zu den verhältnismäßig großen Kontaktpads der Interconnect-Bausteine ausgerichtet werden.

Weitere Ausführungsformen und vorteilhafte Aspekte dieses dreidimensional-integrierten Schaltkreises sind in den jeweils abhängigen Patentansprüchen genannt.

Einige Ausführungsbeispiele sind exemplarisch in der Zeichnung dargestellt und werden nachstehend erläutert. Es zeigen:
- Fig. 1A: eine schematische seitliche Schnittansicht eines erfindungsgemäßen dreidimensional-integrierten Multi-IC Systems gemäß einem Ausführungsbeispiel,
- Fig. 1B: eine schematische Perspektivansicht eines erfindungsgemäßen dreidimensional-integrierten Multi-IC Systems gemäß einem Ausführungsbeispiel,
- Figs. 2A, 2B: jeweils einen vergrößerten Ausschnitt einer seitlichen Schnittansicht eines erfindungsgemäßen dreidimensional-integrierten Multi-IC Systems gemäß einem Ausführungsbeispiel,
- Figs. 3A-3C: jeweils eine schematische Draufsicht auf ein einzelnes Substrat mit darauf angebrachten aktiven IC-Bausteinen und passiven Interconnect-Bausteinen, gemäß Ausführungsbeispielen, und
- Fig. 4: eine schematische Perspektivansicht eines einzelnen Substrats mit darauf angebrachten aktiven IC-Bausteinen und passiven Interconnect-Bausteinen gemäß einem Ausführungsbeispiel.

Im Folgenden werden Ausführungsbeispiele mit Bezug auf die Figuren näher beschrieben, wobei Elemente mit derselben oder ähnlichen Funktion mit denselben Bezugszeichen versehen sind.

Gegenstand der Erfindung ist ein dreidimensional-integriertes Halbleitersystem, insbesondere ein dreidimensional integriertes Multi-IC System, das mehrere einzelne ICs beinhalten kann. Ein dreidimensional-integriertes Multi-IC System zeichnet sich u.a. dadurch aus, dass mehrere Substrate übereinandergestapelt werden. Da Substrate in der Regel flach sind, definiert jedes Substrat eine Substratebene. Auf den Substraten sind jeweils aktive IC-Bausteine angeordnet, weshalb jede Substratebene gleichzeitig auch eine IC-Ebene definiert. Im Kontext der 3D-Integration spricht man von einer horizontalen bzw. lateralen Verschaltung der IC-Bausteine, wenn diese innerhalb ein- und derselben Substratebene miteinander verschaltet sind. Von einer vertikalen Verschaltung der IC-Bausteine spricht man hingegen dann, wenn die einzelnen IC-Bausteine über eine oder mehrere Substratebenen hinweg miteinander verschaltet sind. Sofern also hierin die Begriffe "horizontal" und "vertikal" verwendet werden, so sind diese Begriffe nicht zwangsläufig auf die Orientierung des dreidimensional-integrierten Multi-IC Systems im Raum zu beziehen, sondern innerhalb des auf diesem technischen Fachgebiet üblichen Jargons auszulegen. Das heißt, der Begriff "horizontal" ist synonym zu "parallel zur Substratebene" zu verstehen, und der Begriff "vertikal" ist synonym zu "senkrecht zur Substratebene" zu verstehen.

Die einzelnen Substrate werden vertikal übereinandergestapelt, sodass sich ein vertikaler Schichtstapel ergibt. Innerhalb dieses Schichtstapels können eines oder mehrere dieser Substrate in Form eines dünnen flexiblen Foliensubstrats ausgestaltet sein, welches zerstörungsfrei biegbar ist. Alternativ oder zusätzlich ist es denkbar, dass eines oder mehrere der Substrate in Form eines unflexiblen, nicht zerstörungsfrei biegbaren bzw. starren Halbleitersubstrats (z.B. ein Siliziumsubstrat) ausgestaltet sind. Das heißt, flexible Foliensubstrate und starre Halbleitersubstrate können innerhalb eines Substratstapels miteinander kombiniert werden. Der Einfachheit halber werden nachfolgend flexible Foliensubstrate als nicht limitierende Beispiele eines Substrats innerhalb des Substratstapels beschrieben. Die Beschreibung ist aber ebenso gültig für starre Halbleitersubstrate.

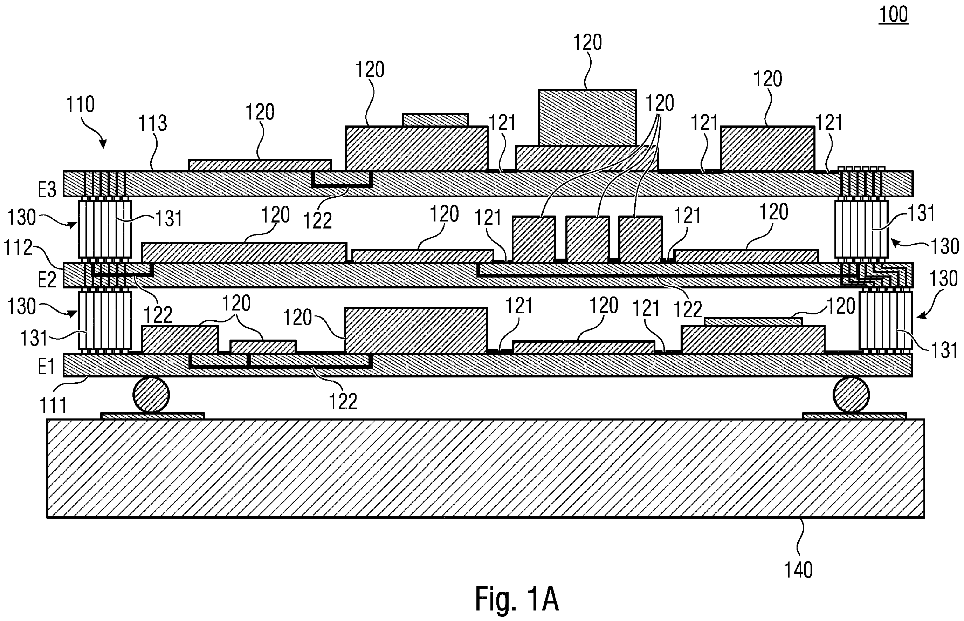

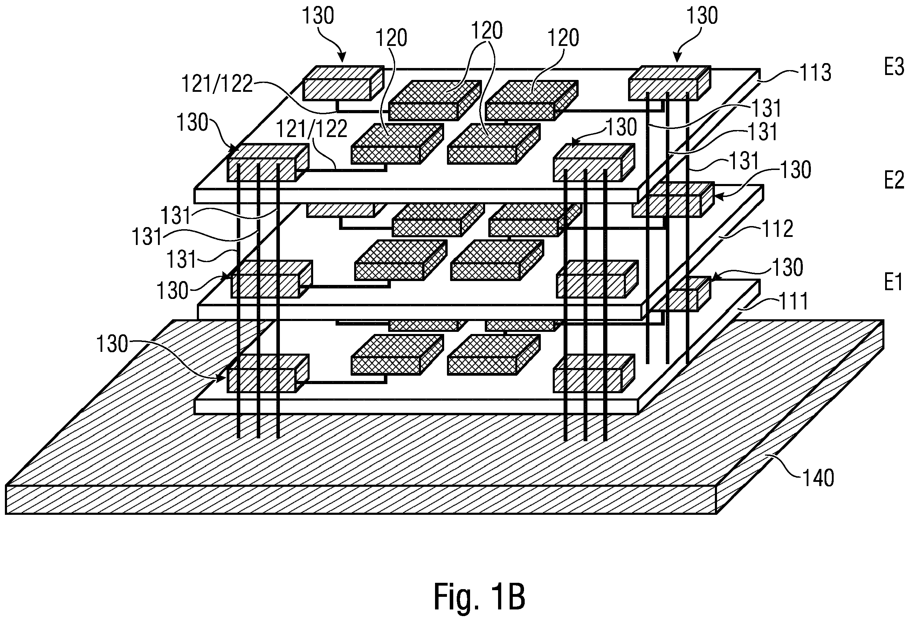

Die Figuren 1A und 1B zeigen jeweils Ausführungsbeispiele eines erfindungsgemäßen dreidimensional-integrierten Multi-IC Systems 100. Figur 1A zeigt eine schematische seitliche Schnittansicht eines dreidimensional-integrierten Multi-IC Systems 100 und Figur 1B zeigt eine schematische Perspektivansicht eines dreidimensional-integrierten Multi-IC Systems 100.

Wie in den Figuren 1A und 1B zu sehen ist, weist das dreidimensional-integrierte Multi-IC System 100 einen Substratstapel 110 auf. Der Substratstapel 110 weist mehrere vertikal übereinander gestapelte Substrate 111, 112, 113 auf. In diesem nicht limitierenden Ausführungsbeispiel sind die Substrate 111, 112, 113 in Form von flexiblen Foliensubstraten ausgestaltet. Der Substratstapel 110 kann daher auch als Foliensubstratstapel bezeichnet werden. Der Foliensubstratstapel 110 kann auf einem Komponententrägersubstrat 140, das z.B. in Form eines PCBs (Printed Circuit Board) vorliegen kann, angebracht und auch elektrisch kontaktiert werden.

Die Foliensubstrate 111, 112, 113 sind flach und erstrecken sich in einer Ebene, die hierin auch als eine Substratebene bzw. Folienebene bezeichnet wird. Somit definiert jedes Substrat 111, 112, 113 jeweils eine Substratebene E1, E2, E3, die im Kontext der 3D-Systemintegration auch als horizontale Substratebene bzw. Folienebene bezeichnet werden kann. Das erste Substrat 111 definiert demnach eine erste Substratebene E1, das zweite Substrat 112 definiert eine zur ersten Substratebene E1 benachbarte zweite Substratebene E2 und das dritte Substrat 113 definiert eine zur zweiten Substratebene E2 benachbarte dritte Substratebene E3. Die zweite Substratebene E2 ist hier zwischen der ersten Substratebene E1 und der dritten Substratebene E3 angeordnet.

In den in den Figuren 1A und 1B gezeigten nicht-limitierenden Ausführungsbeispielen weist der Substratstapel 110 drei übereinandergestapelte Substrate 111, 112, 113 auf. Es ist aber auch denkbar, dass der Substratstapel 110 lediglich zwei übereinandergestapelte Substrate, oder aber auch mehr als die abgebildeten drei übereinandergestapelten Substrate aufweist.

Auf den einzelnen Substraten 111, 112, 113 sind jeweils ein oder mehrere aktive IC-Bausteine 120 (IC: Integrated Circuit / Integrierter Schaltkreis) angeordnet. Die aktiven IC-Bausteine 120 können in Form von ungehäusten Halbleiter-Bausteinen, sogenannten "bare dies", vorliegen. Die aktiven IC-Bausteine 120 können eigenständige abgeschlossene Funktionseinheiten (z.B. Mikrochips) sein. Die IC-Bausteine 120 können aber auch einzelne kleinere Schaltkreise eines größeren Gesamtschaltkreises sein. Dabei kann es sich zum Beispiel um sogenannte Chiplets handeln, wobei Chiplets einzelne kleine Funktionsblöcke eines gesamten Chips darstellen. Die aktiven IC-Bausteine 120 können in Form von dreidimensional integrierten Schaltkreisen, sogenannten 3D-ICs ausgestaltet sein, wobei zwei oder mehr einzelne ICs aufeinandergestapelt und vertikal miteinander verbunden sind (siehe z.B. Figur 1A, die beiden mittleren 3D-ICs in der dritten Folienebene E3).

In allen Fällen können die aktiven IC-Bausteine 120 untereinander elektrisch verschaltet sein, um miteinander kommunizieren zu können. Dabei können sie sowohl in lateraler bzw. horizontaler Richtung, d.h. innerhalb ein- und derselben Substrat- bzw. Folienebene, als auch in vertikaler Richtung, d.h. über mehrere Substrat- bzw. Folienebenen hinweg, untereinander verschaltet sein.

Zum Zwecke der horizontalen Verdrahtung innerhalb ein- und derselben Folienebene können die aktiven IC-Bausteine 120 in der jeweiligen Folienebene E1, E2, E2 elektrisch miteinander verbunden sein. Dies kann beispielsweise mittels dünnen Leiterbahnstrukturen 121 realisiert werden, die auf den Oberflächen der Foliensubstrate 111, 112, 113 aufgebracht sind. Dies kann beispielsweise mittels einem Aufdrucken der jeweiligen Leiterbahnen 121 erfolgen, oder mittels lithographischer Strukturierung. Alternativ oder zusätzlich können die aktiven IC-Bausteine 120 mittels einer integrierten Verdrahtung 122 innerhalb des jeweiligen Foliensubstrats 111, 112, 113 untereinander elektrisch gekoppelt sein.

Zum Zwecke der vertikalen Verdrahtung über mehrere Folienebenen hinweg können die aktiven IC-Bausteine 120 über mindestens zwei benachbarte Folienebenen E1, E2, E2 hinweg elektrisch untereinander verbunden sein. Erfindungsgemäß weist das dreidimensional integrierte Multi-IC System 100 hierfür ein oder mehrere passive Interconnect-Bausteine 130 auf.

Die Interconnect-Bausteine 130 sind jeweils zwischen zwei benachbarten Foliensubstraten 111, 112, 113 angeordnet. Die Interconnect-Bausteine 130 enthalten jeweils ein oder mehrere vertikal verlaufende Signalleitungsstrukturen 131. Diese erstecken sich im Wesentlichen geradlinig im Inneren eines Interconnect-Bausteins 130 durch diesen hindurch, insbesondere zwischen einer einem ersten Substrat 111 zugewandten ersten Seite (z.B. Unterseite) eines Interconnect-Bausteins 130 und einer einem zweiten Substrat 113 zugewandten gegenüberliegenden zweiten Seite (z.B. Oberseite) des jeweiligen Interconnect-Bausteins 130.

Die vertikal verlaufenden Signalleitungsstrukturen 131 können prinzipiell in beliebiger Anzahl und/oder in beliebiger Anordnung innerhalb eines jeweiligen Interconnect-Bausteins 130 vorhanden sein. Die Interconnect-Bausteine 130 können derart ausgestaltet sein, dass sie ausschließlich vertikale Signalleitungsstrukturen 131 aufweisen.

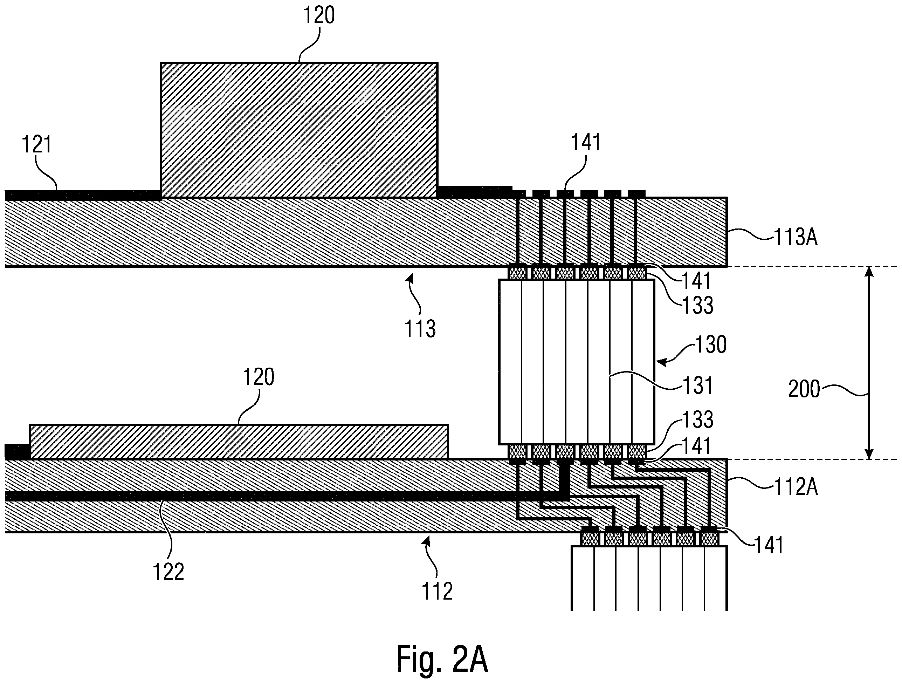

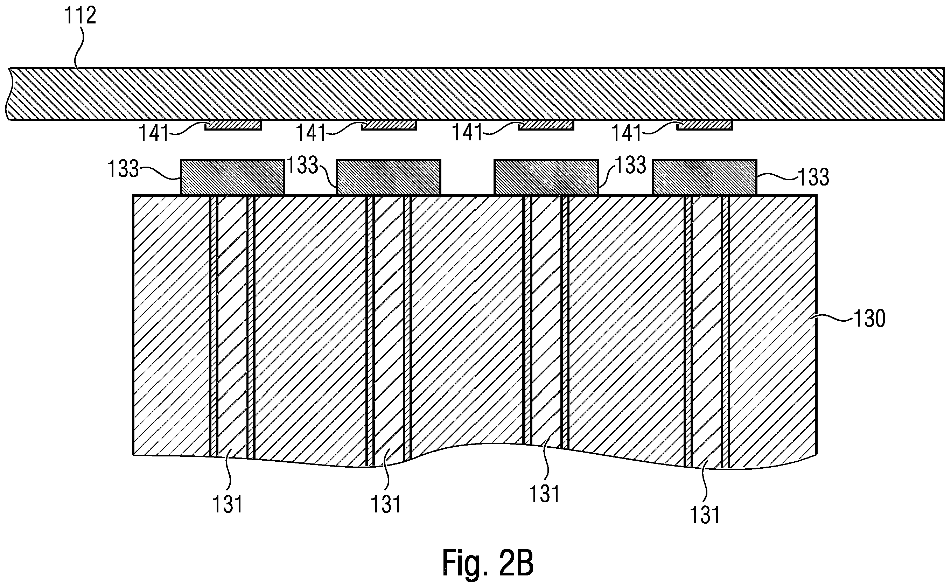

Die vertikal verlaufenden Signalleitungsstrukturen 131 sind ausgestaltet, um eine elektrische Verbindung zwischen je zwei benachbarten Foliensubstraten 111, 112, 113 herzustellen, was nachfolgend unter Bezugnahme auf die Figuren 2A und 2B noch näher erläutert wird.

Dadurch können beispielsweise die auf dem zweiten Foliensubstrat 112 angeordneten IC-Bausteine 120 mit den IC-Bausteinen 120 auf dem darunterliegenden ersten Foliensubstrat 111 und/oder mit den IC-Bausteinen 120 auf dem darüberliegenden dritten Foliensubstrat 113 elektrisch kontaktiert bzw. verbunden werden. Somit kann eine elektrische Verbindung über mehrere Folienebenen E1, E2, E3 hinweg realisiert werden. Dies wird auch als vertikale Kontaktierung bezeichnet. Diese vertikale Kontaktierung zur Verbindung bzw. Kommunikation über mehrere vertikale Ebenen ist kennzeichnend für eine 3D-Systemintegration.

Um die vertikale Kontaktierung über mehrere Folienebenen E1, E2, E3 hinweg zu ermöglichen, sollte in den entsprechenden Folienebenen E1, E2, E3 mindestens ein aktiver IC-Baustein 120 mit mindestens einem Interconnect-Baustein 130 elektrisch verbunden sein. Allgemeiner ausgedrückt können ein oder mehrere aktive IC-Bausteine 120 innerhalb einer Folienebene mit ein oder mehreren passiven Interconnect-Bausteinen 130 auf derselben Folienebene elektrisch verbunden sein. Die IC-Bausteine 120 können dabei unmittelbar mit den Interconnect-Bausteinen 130 verbunden sein, oder mittelbar, d.h. über ein oder mehrere dazwischengeschaltete IC-Bausteine 120.

Die Interconnect-Bausteine 130 können ihrerseits selbst in Form von Chips, und insbesondere in Form von Halbleiterchips, ausgestaltet sein. Dies macht die Herstellung dieser Interconnect-Bausteine 130 unkompliziert, da diese unter Anwendung von ausgereiften Herstellungsverfahren in Chipfabriken hergestellt werden können.

Beispielsweise können die Interconnect-Bausteine 130 ein Halbleitermaterial (z.B. Silizium) aufweisen oder aus einem Halbleitermaterial bestehen. In diesem Fall könnten die vertikal verlaufenden Signalleitungsstrukturen 131 beispielsweise in Form von durch den jeweiligen Interconnect-Baustein 130 hindurch verlaufenden leitfähigen Durchkontaktierungen ausgestaltet sein. Im Falle von Silizium kann es sich dabei beispielsweise um sogenannte TSVs (through silicon vias) handeln.

Alternativ dazu könnten die Interconnect-Bausteine 130 ein elektrisch isolierendes Material aufweisen oder aus einem elektrisch isolierenden Material bestehen, wobei in diesem Falle die vertikal verlaufenden Signalleitungsstrukturen 131 in Form von durch den jeweiligen Interconnect-Baustein 130 hindurch verlaufenden Kanälen ausgestaltet sein könnten, die mit einem elektrisch leitenden Material gefüllt oder beschichtet sind. Diese Variante könnte sich beispielsweise dann anbieten, wenn nur eine geringe Anzahl (z.B. 50 Stück oder weniger) von vertikalen Signalleitungsstrukturen 131 vorgesehen ist.

Die Interconnect-Bausteine 130 können also aus verschiedenen Materialien gefertigt sein. Ist eine große Anzahl von vertikalen elektrischen Kontakten 131 gewünscht, so kann Silizium bevorzugt sein. In diesem Fall können die vertikalen Kontakte 131 als TSV (through silicon via) ausgeführt sein. Für eine kleinere Anzahl von vertikalen Kontakten 131, z.B. weniger als 50 Stück pro Interconnect-Baustein 130, können auch Materialien wie beispielsweise Keramik, Glas oder das Leiterplatten-Material FR4, sowie andere isolierende Materialien zur Herstellung der Interconnect-Bausteine 130 verwendet werden. Die vertikalen Kontakte 131 durch die Interconnect-Bausteine 130 können dann in Form von Metall-gefüllten Bohrungen oder Laserlöchern mit elektrisch leitender Füllung bzw. Beschichtung ausgestaltet sein.

Die Kontaktierung zwischen den Substraten 111, 112, 113 und den jeweiligen dazwischen angeordneten Interconnect-Bausteinen 130 kann über Kontaktpads erfolgen, die auf der (dem einen Substrat 113 zugewandten) Oberseite sowie auf der (dem gegenüberliegenden anderen Substrat 111 zugewandten) Unterseite des Interconnect-Bausteins 130 vorgesehen sind.

Die Figuren 2A und 2B zeigen jeweils vergrößerte Darstellungen der Verbindung bzw. Kontaktierung zwischen einem erfindungsgemäßen Interconnect-Baustein 130 und den einzelnen Substraten 112, 113. Die Substrate 112, 113 weisen jeweils ein oder mehrere Anschlusspads 141 auf, an denen die aktiven IC-Bausteine 120 innerhalb der jeweiligen Substratebene angeschlossen sein können. Die Anschlusspads 141 können jeweils beidseitig auf den jeweiligen Substraten 112, 113 vorgesehen sein.

Außerdem können zwischen zwei Substratebenen die passiven Interconnect-Bausteine 130 mit diesen Anschlusspads 141 kontaktiert werden. Hierfür weisen die Interconnect-Bausteine 130 auf ihrer den Substraten 112, 113 zugewandten Ober- und Unterseite jeweils ein oder mehrere Kontaktpads 133 auf. Die Kontaktpads 133 sind ausgestaltet, um mit den Anschlusspads 141 auf dem jeweiligen Substrat 112, 113 kontaktiert zu werden. Die einzelnen Kontaktpads 133 können jeweils mit genau einer vertikal verlaufenden Signalleitungsstruktur 131 gekoppelt sein, d.h. pro Signalleitungsstruktur 131 kann ein Kontaktpad 133 vorgesehen sein. Dadurch kann eine vertikale elektrische Verbindung der aktiven IC-Bausteine 120 über mehrere Substratebenen hinweg realisiert werden.

Die erfindungsgemäßen Interconnect-Bausteine 130 sind als passive Elemente ausgestaltet. Sie können beispielsweise lediglich die vertikal verlaufenden Signalleitungsstrukturen 131 als alleiniges Funktionsmerkmal aufweisen. Außerdem kann die Anzahl der Signalleitungsstrukturen 131 im Interconnect-Baustein 130 gering gehalten werden. Aus diesen Gründen können die Kontaktpads 133 auf den Ober- und Unterseiten der Interconnect-Bausteine 130, im Vergleich zu Kontaktpads (z.B. I/O Pads) aktiver IC-Bausteine 120, deutlich größer dimensioniert werden. Dies bezieht sich insbesondere auf die lateralen Abmessungen der Kontaktpads 133.

Die (in lateraler Richtung) größer dimensionierbaren Kontaktpads 133 haben den Vorteil, dass auch ein großer Verzug eines Foliensubstrats 112, 113 bei dessen Montage in einem weiten Toleranzbereich ausgeglichen werden kann. Das heißt, selbst wenn sich das Foliensubstrat 112, 113 bei der Montage stark verzieht, können die Anschlusspads 141 am Foliensubstrat 112, 113 immer noch ordnungsgemäß mit den verhältnismäßig großen Kontaktpads 133 der Interconnect-Bausteine 130 kontaktiert werden, da die Kontaktpads 133 jeweils eine verhältnismäßig große Fläche aufweisen, gegenüber der die Anschlusspads 141 des Substrats 112, 113 passgenau ausgerichtet werden können. Die (in lateraler Richtung) vergrößerten Kontaktpads 133 können sozusagen einen (lateralen) Verzug des Foliensubstrats 112, 113 bis zu einem gewissen Maße ausgleichen, wodurch der Einsatz von Folien als Substratmaterial in dem erfindungsgemäßen dreidimensional integrierten Multi-IC System 100 ermöglicht wird. Die gleiche Argumentation gilt auch für den Fall, dass die Anschlusspads 141 des jeweiligen Substrats 112, 113 größer sind als die Kontaktpads 133 am jeweiligen Interconnect-Baustein 130.

Wie in Figur 2A zu sehen ist, können vertikale Signalleitungsstrukturen 132 durch das jeweilige Substrat 112, 113 hindurch verlaufen. Diese können mit den (beidseitig vorhandenen) Anschlusspads 141 auf dem jeweiligen Substrat 112, 113 verbunden sein Die durch das Substrat 112, 113 hindurch verlaufenden vertikalen Signalleitungsstrukturen 132 können bezüglich Anzahl und/oder Positionierung mit ein oder mehreren vertikalen Signalleitungsstrukturen 131 eines Interconnect-Bausteins 130 übereinstimmen, d.h. je eine vertikale Signalleitungsstruktur 131 eines Interconnect-Bausteins 130 kann mit jeweils einer der durch das jeweilige Substrat 112, 113 hindurch verlaufenden vertikalen Signalleitungsstrukturen 132 gekoppelt sein.

Wie in Figur 2A außerdem zu sehen ist, müssen die durch das jeweilige Substrat 112, 113 vertikal hindurch verlaufenden Signalleitungsstrukturen 132 nicht zwangsläufig geradlinig verlaufen, sondern sie können auch Kurven, Knicke und dergleichen aufweisen. Selbiges gilt im Übrigen auch für die durch einen Interconnect-Baustein 130 hindurch verlaufenden vertikalen Signalleitungsstrukturen 131. Wichtig ist, dass sie eine vertikale elektrische Verbindung zwischen mindestens zwei unterschiedlichen bzw. benachbarten Substratebenen E1, E2, E3 bereitstellen.

Die aktiven IC-Bausteine 120 können prinzipiell mittels unterschiedlichen Verfahren auf einem Foliensubstrat 111, 112, 113 kontaktiert werden. Denkbar sind beispielsweise eine Flip-Chip Montage mit Lotmetallisierungen, oder leitfähige Klebstoffe, wie z.B. ACA (anisotropic conductive adhesive) oder ACF (anisotropic conductive film). Auch Thermokompressions-Kontaktierverfahren sind geeignet. Das gleiche gilt für die Interconnect-Bausteine 130.

Die Kontaktpads 133 der Interconnect-Bausteine 130 können beispielsweise mittels einer Lotkontaktierung in Kombination mit einem Underfill-Klebstoff mit den Anschlusspads 141 von je zwei benachbarten Substraten 111, 112, 113 verbunden werden. Auch hier können elektrisch leitfähige Klebstoffe, wie zum Beispiel ACA oder ACF eingesetzt werden.

Ein Vorteil bei der Verwendung derartiger Lotverbindungen und/oder leitfähiger Klebstoffe besteht unter anderem darin, dass neben der elektrischen Vertikal-Kontaktierung zugleich auch eine mechanische Fixierung zwischen den einzelnen Subtraten 111, 112, 113 erfolgt. Das heißt, die mechanische Fixierung zwischen den Substratebenen E1, E2, E3 erfolgt automatisch über den Klebstoff an den Kontaktpads 133 an den Ober- und Unterseiten der Interconnect-Bausteine 130.

Ausführungsbeispiele der Erfindung sehen daher vor, dass ein Interconnect-Baustein 130 mittels einer Lotkontaktierung und/oder mittels eines leitfähigen Klebstoffs an den jeweiligen Anschlusspads 141 zweier benachbarter Substrate 112, 113 angebracht ist, wodurch die zwei benachbarten Substrate 112, 113 elektrisch und mechanisch miteinander fixiert sind.

Dadurch kann eine sehr gute mechanische Fixierung erzielt werden, die zudem über die Anzahl der Interconnect-Bausteine 130 steuerbar ist. Die Verklebung der Interconnect-Bausteine 130 mit den Substraten 111, 112, 113 stellt zudem keine Begrenzung der Wärmeabfuhr dar, da die Interconnect-Bausteine 130 keine aktiven, also leistungsverbrauchenden sowie wärmeerzeugenden Bauelemente sind.

Die Interconnect-Bausteine 130 können außerdem zur Wärmeabfuhr zwischen den einzelnen Substratebenen E1, E2, E3 genutzt werden. Dies ergibt sich aus der Tatsache, dass die in den Interconnect-Bausteinen 130 vertikal verlaufenden Signalleitungsstrukturen 131 Metalle aufweisen können, wobei Metalle die Wärme grundsätzlich gut ableiten.

Die erfindungsgemäßen Interconnect-Bausteine 130 dienen allerdings nicht nur zur vertikalen Kontaktierung. Sie können auch als, im Wesentlichen gleichförmige, Abstandshalter zwischen zwei benachbarten Substraten 111, 112, 113 eingesetzt werden.

Erfindungsgemäß sind die Interconnect-Bausteine 130 dabei derart dimensioniert, dass ein Substrat 112 nicht mit IC-Bausteinen 120 eines darunterliegenden benachbarten Substrats 111 in Berührung kommt. Das heißt, die Interconnect-Bausteine 130 sorgen dafür, dass ein Substrat 112 in einer ersten Substratebene E2 von den IC-Bausteinen 120 eines benachbarten Substrats 111 in einer zweiten Substratebene E1 beabstandet ist. Dies wird erfindungsgemäß dadurch sichergestellt, dass die auf einem Substrat 111, 112, 113 angeordneten Interconnect-Bausteine 130 jeweils höher sind als der jeweils höchste aktive IC-Baustein 120 auf demselben Substrat 111, 112, 113. Die Bauteilhöhe bemisst sich hierbei in vertikaler Richtung, d.h. senkrecht zur jeweiligen Substratebene E1, E2, E3.

In den bisher diskutierten Ausführungsformen wurden Foliensubstrate als Beispiele für die verwendbaren Substrate 111, 112, 113 innerhalb eines Substratstapels 110 beschrieben. In einigen Ausführungsformen ist es denkbar, dass ein oder mehrere der Substrate 111, 112, 113 innerhalb des Substratstapels 110 in Form von unflexiblen bzw. starren Halbleitersubstraten, z.B. in Form von Interposern, ausgestaltet sind. Die Halbleitersubstrate können beispielsweise Silizium aufweisen oder aus Silizium bestehen.

Starre Halbleitersubstrate sind stabiler bzw. steifer als Foliensubstrate, weshalb es zu deutlich weniger Verzug bei der Montage kommt. Im Gegensatz zu flexiblen Foliensubstraten können die starren Halbleitersubstrate jedoch Höhenunterschiede zwischen einzelnen IC-Bausteinen 120 deutlich weniger gut ausgleichen. Insbesondere beim Einsatz von Halbleitersubstraten ist es daher empfehlenswert, wenn die Interconnect-Bausteine 130 einer Substratebene E1, E2, E3 im Wesentlichen die gleiche Höhe aufweisen. Beispielsweise können die einzelnen Interconnect-Bausteine 130 um weniger als 30 µm, oder um weniger als 10 µm, oder sogar um weniger als 5 µm in der Höhe voneinander abweichen. Im Falle von starren Halbleitersubstraten wäre es denkbar, dass die einzelnen Interconnect-Bausteine 130 um weniger als 2 µm, oder sogar um weniger als 1 µm in der Höhe voneinander abweichen.

Da die Interconnect-Bausteine 130 als universelle Bausteine gefertigt werden können, ist es auch denkbar, dass alle innerhalb eines gesamten Multi-IC Systems 100 zum Einsatz kommenden Interconnect-Bausteine 130 im Wesentlichen die gleiche Höhe aufweisen, ganz unabhängig davon zwischen welchen Substraten 111, 112, 113 bzw. Substratebenen E1, E2, E3 die Interconnect-Bausteine 130 angeordnet sind.

Prinzipiell können die Interconnect-Bausteine 130 dort angeordnet werden, wo Platz ist. Das heißt, sie können an beliebigen freien Stellen auf dem jeweiligen Substrat 111, 112, 113 positioniert werden. Wie in Figur 1A zu sehen ist, können die Interconnect-Bausteine 130 beispielsweise entlang von lateralen Außenkanten des jeweiligen Substrats 111, 112, 113 angeordnet werden. Dabei kann die Außenkontur des Interconnect-Bausteins 130 mit der Außenkante des jeweiligen Substrats 111, 112, 113 bündig abschließen. Dies ist beispielhaft mit dem, in Figur 1A unten rechts eingezeichneten, Interconnect-Baustein 130 dargestellt. Es ist aber auch denkbar, dass die Interconnect-Bausteine 130 lateral nach innen, in Richtung Zentrum des jeweiligen Substrats 111, 112, 113, versetzt sind. Dies wiederum ist beispielhaft anhand der übrigen Interconnect-Bausteine 130 in Figur 1A dargestellt.

Interconnect-Bausteine 130, die übereinander, d.h. auf unterschiedlichen Substratebenen E1, E2, E3, angeordnet sind, können in vertikaler Stapelrichtung gesehen lateral überlappen, d.h. sie können lateral links oder rechts zueinander versetzt sein. Dies ist anhand der beiden rechten Interconnect-Bausteine 130 in Figur 1A gezeigt.

Ein vorteilhaftes Ausführungsbeispiel sieht vor, dass die auf unterschiedlichen Substratebenen E1, E2, E3 befindlichen Interconnect-Bausteine 130 in vertikaler Stapelrichtung gegenüberliegend voneinander angeordnet sind, vorzugsweise ohne einen lateralen Versatz. Das heißt die Außenkonturen von, in unterschiedlichen Substratebenen E1, E2, E3 befindlichen, übereinander angeordneten Interconnect-Bausteinen 130 liegen in einer gemeinsamen Flucht. Dies ist anhand der beiden, in Figur 1A links eingezeichneten, Interconnect-Bausteine 130 dargestellt.

Die in verschiedenen Substratebenen E1, E2, E3 befindlichen Interconnect-Bausteine 130 sind also bevorzugt vertikal übereinander gestapelt. Somit wird bei der 3D-Montage bzw. beim Stapeln der einzelnen Substrate 111, 112, 113 der mechanische Druck immer auf die stabilen Interconnect-Bausteine 130 übertragen. Somit sind zum Verbinden der einzelnen Substrate 111, 112, 113 auch druckgesteuerte Verbindungstechniken möglich, ohne dass die aktiven IC-Bausteine 120 auf den jeweiligen Substraten 111, 112, 113 mechanisch belastet werden.

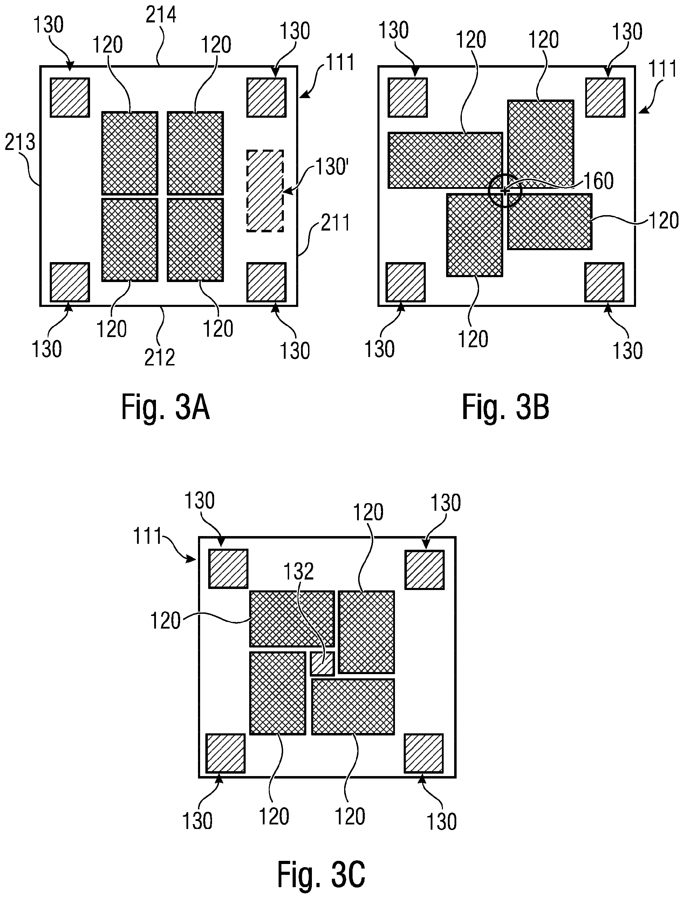

Die Figuren 3A, 3B und 3C zeigen jeweils eine Draufsicht auf ein einzelnes Substrat 111, um beispielhafte Anordnungen der Interconnect-Bausteine 130 sowie der aktiven IC-Bausteine 120 zu demonstrieren. Diese Anordnungen gelten ebenso auch für andere Substrate 112, 113 bzw. andere Substratebenen.

Die geometrische Form der Interconnect-Bausteine 130 kann zunächst beliebig sein. Vorzugsweise können die Interconnect-Bausteine 130 viereckig sein. Die Interconnect-Bausteine 130 können quadratisch oder rechteckig (siehe Interconnect-Baustein 130' in Figur 3A) sein.

Das Substrat 111 selbst kann ebenfalls eine viereckige, z.B. quadratische oder rechteckige, Form aufweisen. Die Interconnect-Bausteine 130 können beispielsweise in allen vier Ecken des viereckigen Substrats 111 positioniert sein.

Alternativ oder zusätzlich können ein oder mehrere Interconnect-Bausteine 130 entlang der lateralen Außenkanten 211, 212, 213, 214 (Figur 3A) des Substrats 111 positioniert sein, was anhand des in Strichlinien dargestellten optionalen Interconnect-Bausteins 130' dargestellt ist.

Prinzipiell können beliebig viele Interconnect-Bausteine 130 an beliebigen freien Stellen auf dem Substrat 111 angeordnet werden. Eine große Anzahl von Interconnect-Bausteinen 130 kann beispielsweise vorteilhaft sein, um das Substrat 111 zusätzlich abzustützen. Falls keine elektrische Vertikal-Kontaktierung von Nöten ist, so können auch zusätzliche passive Interconnect-Bausteine 132 (Figur 3C) zum Einsatz kommen, die keine vertikal verlaufenden Signalleitungsstrukturen 131 aufweisen. Um einen gleichmäßigen Abstand zwischen zwei Substratebenen zu gewährleisten, ist es vorteilhaft, wenn diese zusätzlichen Interconnect-Bausteine 132 gleich hoch sind wie die übrigen Interconnect-Bausteine 130, oder um weniger als 30 µm, oder um weniger als 10 µm oder sogar um weniger als 5 µm in der Höhe von den übrigen Interconnect-Bausteinen 130 abweichen.

Prinzipiell kann auch die Anordnung der aktiven IC-Bausteine 120 weitestgehend frei auf dem Substrat 111 gewählt werden. Die IC-Bausteine 120 können beispielsweise in jeweils gleicher Ausrichtung nebeneinander angeordnet werden (Figur 3A). Die IC-Bausteine 120 können aber auch Mühlrad-artig angeordnet werden, wobei von jedem IC-Baustein 120 jeweils eine Ecke zu einem gemeinsamen Mittelpunkt 160 zeigt (Figur 3B). Die IC-Bausteine 120 können aber auch Fenster-artig angeordnet werden, wobei die IC-Bausteine 120 eine viereckige Außenkontur definieren (Figur 3C). In den beiden letztgenannten Ausführungsbeispielen können immer jeweils zwei benachbarte IC-Bausteine 120 um 90° zueinander versetzt angeordnet sein.

Es kann vorteilhaft sein, die Interconnect-Bausteine 130 vermehrt in Bereichen zu platzieren, in denen die aktiven IC-Bausteine 120 in den einzelnen Substratebenen E1, E2, E2 einen erhöhten Wärmeabfluss generieren, da die Interconnect-Bausteine 130 diese Wärme ableiten können, insbesondere wenn sie in Form von Silizium-Bausteinen mit vielen TSV Kontakten ausgeführt sind.

Insbesondere in Fällen, in denen es sich bei den aktiven IC-Bausteinen 120 um Chiplets handelt, ist eine eng beieinander liegende Platzierung wünschenswert, um kurze Verbindungswege zwischen den Chiplets 120 zu realisieren. Daher sehen Ausführungsbeispiele der Erfindung vor, dass zwei, auf demselben Substrat 111 lateral benachbart angeordnete, aktive IC-Bausteine 120 in einem Abstand von 10 µm bis 300 µm zueinander angeordnet sind. Dies kann ermöglicht werden, indem sehr feine Metall-Leiterbahnstrukturen auf einem Substrat 111 aufgebracht werden, auf denen dann wiederum die IC-Bausteine 120 angeordnet werden können. Dies ermöglicht eine mikrometergenaue Platzierung der IC-Bausteine 120 mit sehr engen Abständen, z.B. lediglich 10 µm bis 50 µm Abstand zum Nachbar-IC.

Hierfür kann es vorteilhaft sein, Polyimid-Folien als Substratmaterial für die Substrate 111, 112, 113 zu verwenden, da diese mit den zuvor erwähnten feinen Metall-Leiterbahnstrukturen versehen werden können. Polyimid-Folien haben auch weitere Vorteile. So sind sie unter anderem thermisch stabil, sodass Lotprozesse zur Kontaktierung der IC-Bausteine 120 und/oder der Interconnect-Bausteine 130 auf dem jeweiligen Foliensubstrat 111, 112, 113 eingesetzt werden können. Ebenfalls denkbar wären Folien mit für Hochfrequenz-Anwendungen adaptierten dielektrischen Eigenschaften.

Auch der Aspekt der Wärmeabfuhr ist bei vertikalen 3D-integrierten Multi-IC Systemen 100 von großer Bedeutung. Je mehr aktive IC-Bausteine 120 pro Substratebene E1, E2, E3 verbaut sind, und je mehr Substrate 111, 112, 113 übereinandergestapelt sind, desto größer wird die durch die aktiven IC-Bausteine 120 erzeugte Wärme. Um Ausfälle einzelner IC-Bausteine 120 oder sogar einen Ausfall des gesamten 3D-integrierten Multi-IC Systems 100 zu vermeiden, muss diese Abwärme effizient aus dem Substratstapel 110 herausgeführt werden.

Daher sehen Ausführungsbeispiele der Erfindung vor, dass je zwei benachbarte Substrate 112, 113 an deren jeweiligen lateralen Außenseiten 112A, 113A (Figur 2A) vertikal voneinander beabstandet sind, sodass Luft zwischen diesen beiden benachbarten Substraten 112, 113 zirkulieren kann. Dies ist in Figur 2A symbolisch anhand des Doppelpfeils 200 dargestellt. Dies kann auf einfache Art und Weise mittels der erfindungsgemäßen Interconnect-Bausteine 130 ermöglicht werden.

Dies ist insbesondere bei Foliensubstraten vorteilhaft, da so der Folienstapel 110 weitestgehend "offen" bleiben kann. Die Wärme produzierenden aktiven IC-Bausteine 120 auf den einzelnen Foliensubstraten 111, 112, 113 sind also, im Vergleich zu bisher bekannten Einbett-Technologien in Leiterplatten, nicht vollständig eingebettet oder verkapselt. Somit können auch die inneren Bereiche der jeweiligen Foliensubstrate 111, 112, 113 von einem Luftstrom (passiv oder aktiv) gekühlt werden. Eine solche Anordnung ermöglicht eine deutlich verbesserte Wärmeabfuhr. Gleiches gilt aber natürlich auch für starre Halbleitersubstrate.

Eine weitere Verbesserung der Wärmeabfuhr kann erzielt werden, indem ungenutzte Bereiche auf den Substraten 111, 112, 113 mit einer Metallschicht, z. B. Kupfer, versehen werden. Dies ergibt eine größere Kühlfläche und hilft die Wärme zu spreizen. Diese Kupfer-Kühlflächen sollten elektrisch getrennt sein von den elektrischen Verbindungen zwischen den IC-Bausteinen 120 und/oder den Interconnect-Bausteinen 130.

Wie eingangs bereits erwähnt wurde, können die elektrischen Verbindungsleitungen zwischen den IC-Bausteinen 120 und/oder den Interconnect-Bausteinen 130 in Form von auf das jeweilige Substrat 111, 112, 113 aufgebrachten Leiterbahnstrukturen 121 und/oder in Form von in das Substrat 111, 112, 113 integrierten Verdrahtungen 122 ausgestaltet sein.

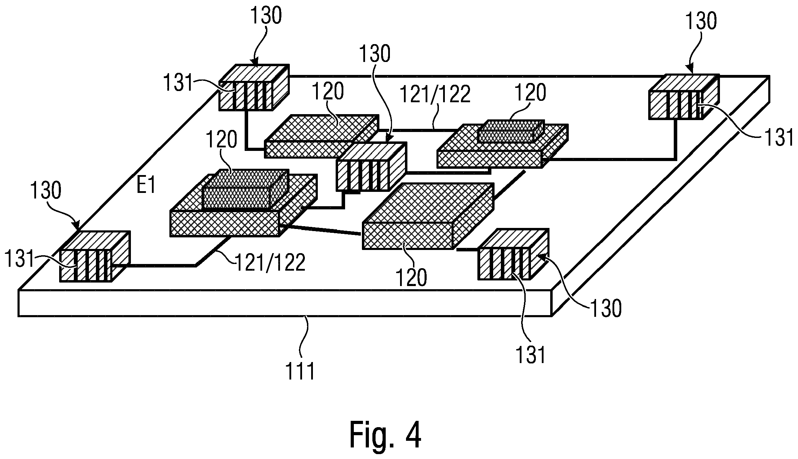

Figur 4 zeigt abschließend nochmals eine schematische Perspektivansicht eines einzelnen Substrats 111 bzw. einer einzelnen Substratebene E1 mit einem beispielhaften lateralen bzw. horizontalen Verbindungs-Layout zwischen mehreren IC-Bausteinen 120 und Interconnect-Bausteinen 130. Prinzipiell ist es denkbar, dass innerhalb ein- und derselben Substratebene E1 ein oder mehrere aktive IC-Bausteine 120 mit ein oder mehreren anderen aktiven IC-Bausteinen 120 verbunden sind. Das heißt, die auf der gleichen Substratebene E1 befindlichen IC-Bausteine 120 können unmittelbar oder mittelbar horizontal untereinander verbunden sein.

Es wäre aber auch denkbar, dass einzelne IC-Bausteine 120 innerhalb einer Substratebene E1 nicht horizontal mit anderen IC-Bausteinen 120 auf dieser Substratebene E1 verbunden sind, sondern stattdessen ausschließlich vertikal mit IC-Bausteinen 120 auf anderen Substratebenen E2, E3 verbunden sind. Hierzu könnten sie horizontal ausschließlich mit einem oder mehreren Interconnect-Bausteinen 130 verbunden sein, die die vertikale Verbindung zum jeweils benachbarten Substrat herstellen. Generell können also innerhalb einer Substratebene E1 ein oder mehrere IC-Bausteine 120 unmittelbar oder mittelbar mit ein oder mehreren Interconnect-Bausteinen 130 kontaktiert sein.

Ein weiterer wichtiger Aspekt bei der 3D-Systemintegration ist die Erzielung einer möglichst großen Übertragungsrate, und zwar in horizontaler als auch in vertikaler Richtung. Um hohe Übertragungsraten zwischen den auf einer Substratebene E1, E2, E3 horizontal miteinander verbundenen IC-Bausteinen 120 zu ermöglichen, können die Verbindungsleitungen 121, 122 auf dem jeweiligen Substrat 111 beispielsweise als Hochfrequenz-taugliche Leiterbahnen ausgestaltet sein. Hierbei kann es sich beispielsweise um sogenannte "grounded coplanar wave guides" (GCPW) handeln. In diesem Fall lägen auf der Oberseite des jeweiligen Substrats 111 die Signalleitungen 121, 122 zwischen (hier nicht dargestellten) "Ground-Leitungen" in einem bestimmten Abstand zueinander, und an der Unterseite des Substrats 111 wäre eine leitfähige Schicht als "Ground-Ebene" aufgebracht. Zwischen den einzelnen "Ground-Abschnitten" an der Ober- und Unterseite des Substrats 111 könnten zudem elektrisch leitfähige Vias vorgesehen sein, die sich durch das Substrat 111 hindurch erstrecken. Die Vias könnten in Form von Via-Ketten entlang der Richtung der Signal-Leitungen angeordnet sein.

Derartige RF-Leitungen ("transmission lines") lassen sich auf Foliensubstraten besonders gut realisieren. Ein wichtiger Vorteil dabei ist die vorhandene Glattheit von Folienoberflächen, insbesondere im Falle von Polyimid-Folien. Diese Glattheit hilft bei der Reduzierung von Verlusten entlang der Leiterbahnen. Somit ermöglicht die erfinderische Folienarchitektur auch die Ausführung von hoch performanten elektrischen Verbindungen 121, 122 zwischen den einzelnen IC-Bausteinen 120 und/oder Interconnect-Bausteinen 130.

Zusammenfassend können mit dem hierin vorgestellten innovativen Konzept mehrere verschiedenartige IC-Bausteine 120 auf einem einzelnen Substrat 111, 112, 113 horizontal elektrisch miteinander verbunden werden. Im Falle einer Integration von Chiplet-Bausteinen 120 können diese sehr eng nebeneinander montiert werden, z.B. im Abstand von nur 10 µm bis 300 µm. Die aktiven IC-Bausteine 120 können auch in Form von gestapelten Chips (3D-IC) auf einem Substrat 111, 112, 113 platziert und elektrisch kontaktiert werden. Die aktiven IC-Bausteine 120 können als ungehäuste ("bare die") Bausteine montiert und kontaktiert werden.

Die vertikale elektrische Verbindung zu einer darüber oder darunter liegenden Substratebene erfolgt über gesonderte Chip-Bausteine, sogenannte Interconnect-Bausteine 130, die im Wesentlichen zwei Funktionen erfüllen können. Sie können zum Einen als im Wesentlichen gleichförmige Abstandshalter zwischen zwei Substratebenen dienen, und zum Anderen können sie 3D-Leiterbahnstrukturen 131 (z.B. TSV "through silicon via") enthalten, die zwischen der Ober- und Unterseite der Interconnect-Bausteins 130 verlaufen.

Die Höhe der Interconnect-Bausteine 130 innerhalb einer Substratebene ist weitgehend gleich, bevorzugt mit einer Variation von unter 30 µm. Zudem kann ihre Höhe größer sein als der höchste, auf derselben Substratebene vorkommende, IC-Baustein 120.

Die Integration von vielen aktiven IC-Bausteinen 120 zu einem größeren Chip-System 100 birgt die Gefahr eines großen Ausschuss-Risikos, falls erst am Schluss der Integration ein elektrischer Test möglich ist. Mit dem hier vorgestellten innovativen Konzept können hingegen bereits die einzelnen Substratebene vor der 3D-Integation auf elektrische Funktion getestet werden. Falls die einzelnen aktiven IC-Bausteine 120 auf einer Substratebene aufgelötet wurden, wäre es sogar möglich, eine Reparatur auszuführen, und einen Chip zu ersetzen.

Die Testbarkeit der einzelnen Substratebenen sowie die Reparierbarkeit der IC-Bausteine 120 auf den einzelnen Ebenen bietet den Vorteil der verbesserten Produktivität für die Fertigung solcher komplexer 3D-Chip-Systeme 100.

Das hierin vorgestellte Konzept zur 3D-Systemintegration weist viele weitere Vorteile auf. Die neue Chip-Architektur ermöglicht sowohl eine vertikale Integration von mehreren IC-Bausteinen 120 als auch eine Querverbindung zwischen mehreren aktiven IC-Bausteinen 120 in einer einzelnen Substratebene. Das Konzept ist modular, d.h. in jeder Substratebene können die eingesetzten IC-Bausteine 120 leicht ausgetauscht werden, um sie z.B. durch die nächste Generation von IC-Bausteinen 120 zu ersetzen. Die hochfunktionalen aktiven IC-Bausteine 120 (Prozessor-ICs) müssen selbst keine aufwändigen TSV Strukturen im Chip aufweisen, um eine vertikale Kontaktierung zu ermöglichen, was deren Herstellung deutlich kostengünstiger und auch platzsparender macht. Erfindungsgemäß sind die vertikalen Kontaktelemente stattdessen in den passiven Interconnect-Bausteinen 130 integriert.

Die Interconnect-Bausteine 130 für die vertikale Integration sind einfache und kostengünstige Massenware, die universell und somit modular nutzbar sind. Die "offene" Architektur des Substratstapels 110 bietet gute Möglichkeiten zur Wärmeabfuhr aus dem Inneren.

Das hierin vorgestellte innovative Konzept kann beispielsweise eingesetzt werden für die 3D-Integration von Chip-Bausteinen, für miniaturisierte Chip-Systeme, zur Integration von Chiplets oder zum Stapeln von Chiplets. Dieses Konzept zur 3D-Systemintegration weist zudem ein großes Potential für neuromorphe Rechenarchitekturen auf.

Die vorliegende Erfindung ermöglicht die Kombination von folgenden Vorteilen in einer neuen modularen Architektur:
- Kleinere Prozessoreinheiten 120 (z. B. Chiplets) können in einer Substratebene sehr eng und dicht nebeneinander platziert werden und untereinander kommunizieren
- Zwischen übereinander liegenden IC-Ebenen können viele Verbindungsleitungen realisiert werden
- Das entstehende offene 3D-System ermöglicht eine gute Wärmeableitung
- Die einzelnen IC-Bausteine 120 im System 100 können variabel kombiniert werden, d.h. es können auch Prozessor-ICs 120 eingesetzt werden, die keine Spezial-Designs für 3D-Integration, z B. "through silicon via" (TSV) im Chip, in der Fertigung erfordern. Somit wird eine modulare Architektur für unterschiedliche IC-Bausteine 120 erreicht.

Die vorliegende Erfindung bietet ein Konzept für ein 3D-Stacking mit Quervernetzung in allen Ebenen und schafft damit eine Grundlage für eine modulare Chip-Architektur für neuromorphes Computing.

Die Verwendung von Folien als Substratmaterial für die einzelnen Substratebene bietet den Vorteil, geringe Höhenunterschiede mit den Interconnect-Bausteinen 130 ausgleichen zu können und somit eine weitgehend planparallele Stapelung der Foliensubstrate 111, 112, 113 zu ermöglichen. Dennoch widerspricht die Wahl einer flexiblen Folie als Substratmaterial für eine IC-Ebene dem bisher gängigen Fachwissen, da eine Folie immer auch das Risiko eines geometrischen Verzugs aufweist

Erfindungsgemäß wird dieses Problem unter anderem dadurch gelöst, dass die Interconnect-Bausteine 130 größere Kontaktpads 133 aufweisen können, um tolerant gegenüber Verzug in der Folie zu werden. Dies ist zunächst nicht naheliegend, da auf einem Prozessor-IC kein Platz für vergrößerte Kontaktflächen ist, bzw. der Flächenbedarf in der relativ teuren Silizium-Wafer-Prozessierung wäre viel zu teuer. Ziel ist es ja gerade den Flächenbedarf von IC-Bausteinen zu reduzieren. Daher sieht die erfinderische Lösung eine getrennte Ausführung von horizontaler und vertikaler Kontaktierung vor, indem Bausteine 130 für die elektrische Verbindung zwischen den einzelnen Substratebenen bereitgestellt werden, während die IC-Bausteine 120 selbst lediglich horizontal untereinander mit anderen IC-Bausteinen 120 auf derselben Substratebene gekoppelt sind.

Die dadurch erforderliche Herstellung von separaten Bausteinen 130 nur für die vertikale elektrische Verbindung zwischen den Substraten 111, 112, 113 würde aus Kostengründen zunächst wohl nicht unmittelbar in Betracht gezogen werden. Dies wird jedoch durch die modulare Architektur des erfindungsgemäßen Konzepts ermöglicht. Die Interconnect-Bausteine 130 können dabei beispielsweise mit einem Standard Array von TSV-Kontakten ausgestattet sein. Dafür genügt wenig Platz auf dem Chip und der Chip kann für viele verschiedene gestapelte Systeme verwendet werden. Außerdem können die Interconnect-Chips 130 in gleichförmiger und reproduzierbarer Höhe in großen Mengen hergestellt werden. Somit wird die Herstellung solcher universell nutzbarer Interconnect-Chips 130 tatsächlich wieder kosteneffektiv.

Die oben beschriebenen Ausführungsbeispiele stellen lediglich eine Veranschaulichung der Prinzipien des hierin beschriebenen innovativen Konzepts dar. Es versteht sich, dass Modifikationen und Variationen der hierin beschriebenen Anordnungen und Einzelheiten anderen Fachleuten einleuchten werden. Deshalb ist beabsichtigt, dass das hierin beschriebene Konzept lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

## Patentansprüche

1. Dreidimensional-integriertes Multi-IC System (100) (IC: Integrated Circuit/Integrierter Schaltkreis), aufweisend:
einen Substratstapel (110) mit mehreren vertikal übereinander gestapelten Substraten (111, 112, 113), wobei jedes Substrat (111, 112, 113) jeweils eine Substratebene (E1, E2, E3) definiert,
wobei auf den einzelnen Substraten (111, 112, 113) jeweils aktive IC-Bausteine (120) angeordnet sind, die in der jeweiligen Substratebene (E1, E2, E3) elektrisch untereinander verbunden sind, und
passive Interconnect-Bausteine (130), die zwischen zwei benachbarten Substraten (111, 112, 113) angeordnet sind, wobei die Interconnect-Bausteine (130) jeweils vertikal verlaufende Signalleitungsstrukturen (131) aufweisen, die ausgestaltet sind, um eine elektrische Verbindung zwischen je zwei benachbarten Substraten (111, 112, 113) herzustellen.

2. Dreidimensional-integriertes Multi-IC System (100) nach Anspruch 1,
wobei eines oder mehrere der Substrate (111, 112, 113) in Form eines flexiblen Foliensubstrats ausgestaltet ist / sind.

3. Dreidimensional-integriertes Multi-IC System (100) nach Anspruch 1 oder 2,
wobei eines oder mehrere der Substrate (111, 112, 113) in Form eines starren Halbleitersubstrats ausgestaltet ist / sind.

4. Dreidimensional-integriertes Multi-IC System (100) nach einem der Ansprüche 1 bis 3,
wobei die auf jeweils einem der Substrate (111, 112, 113) angeordneten Interconnect-Bausteine (130) jeweils höher sind als der jeweils höchste aktive IC-Baustein (120) auf demselben Substrat (111, 112, 113).

5. Dreidimensional-integriertes Multi-IC System (100) nach einem der Ansprüche 1 bis 4,
wobei die einzelnen, zwischen jeweils zwei benachbarten Substraten (111, 112, 113) angeordneten, Interconnect-Bausteine (130) untereinander jeweils gleich hoch sind, oder um weniger als 30 µm in der Höhe voneinander abweichen.

6. Dreidimensional-integriertes Multi-IC System (100) nach einem der Ansprüche 1 bis 5,
wobei in unterschiedlichen Substratebenen (E1, E2, E3) befindliche Interconnect-Bausteine (130) jeweils, in vertikaler Schichtstapelrichtung, gegenüberliegend voneinander angeordnet sind.

7. Dreidimensional-integriertes Multi-IC System (100) nach einem der Ansprüche 1 bis 6,
wobei je zwei benachbarte Substrate (112, 113) an deren jeweiligen lateralen Außenseiten (112A, 113A), mittels der Interconnect-Bausteine (130), vertikal voneinander beabstandet (200) sind, sodass Luft zwischen diesen beiden benachbarten Substraten (112, 113) zirkulieren kann.

8. Dreidimensional-integriertes Multi-IC System (100) nach einem der Ansprüche 1 bis 7,
wobei innerhalb einer Substratebene (E1, E2, E3) jeweils mindestens ein aktiver IC-Baustein (120) mit jeweils mindestens einem passiven Interconnect-Baustein (130) elektrisch verbunden ist.

9. Dreidimensional-integriertes Multi-IC System (100) nach einem der Ansprüche 1 bis 8,
wobei ein oder mehrere der Interconnect-Bausteine (130) ein Halbleitermaterial aufweisen oder aus einem Halbleitermaterial bestehen, und
wobei die vertikal verlaufenden Signalleitungsstrukturen (131) in Form von durch den jeweiligen Interconnect-Baustein (130) hindurch verlaufenden leitfähigen Durchkontaktierungen ausgestaltet sind.

10. Dreidimensional-integriertes Multi-IC System (100) nach einem der Ansprüche 1 bis 9,
wobei ein oder mehrere der Interconnect-Bausteine (130) ein elektrisch isolierendes Material aufweisen oder aus einem elektrisch isolierenden Material bestehen, und
wobei die vertikal verlaufenden Signalleitungsstrukturen (131) in Form von durch den jeweiligen Interconnect-Baustein (130) hindurch verlaufenden Kanälen ausgestaltet sind, die mit einem elektrisch leitenden Material gefüllt oder beschichtet sind.

11. Dreidimensional-integriertes Multi-IC System (100) nach einem der Ansprüche 1 bis 10,
wobei die Substrate (111, 112, 113) jeweils ein oder mehrere Anschlusspads (141) aufweisen, und wobei die Interconnect-Bausteine (130) jeweils elektrische Kontaktpads (133) aufweisen, die mit deren jeweiligen vertikalen Signalleitungsstrukturen (131) verbunden sind, und
wobei je ein Kontaktpad (133) eines Interconnect-Bausteins (130) mit je einem Anschlusspads (141) eines Substrats (112, 113) elektrisch kontaktiert ist, sodass eine elektrisch leitfähige Verbindung zwischen den Anschlusspads (141) der jeweiligen Substrate (112, 113) und den vertikal verlaufenden Signalleitungsstrukturen (131) des zwischen diesen Substraten (112, 113) angeordneten Interconnect-Bausteins (130) besteht.

12. Dreidimensional-integriertes Multi-IC System (100) nach Anspruch 11,
wobei die Kontaktpads (133) der Interconnect-Bausteine (130) mittels einer Lotkontaktierung und/oder mittels eines leitfähigen Klebstoffs an den jeweiligen Anschlusspads (141) der zwei benachbarten Substrate (112, 113) angebracht sind, wodurch die zwei benachbarten Substrate (112, 113) elektrisch und mechanisch miteinander fixiert sind.

13. Dreidimensional-integriertes Multi-IC System (100) nach einem der Ansprüche 1 bis 12,
wobei zwischen zwei benachbarten Substraten (111, 112, 113) mindestens ein zusätzlicher passiver Interconnect-Baustein (132) angeordnet ist, der keine vertikal verlaufenden Signalleitungsstrukturen (131) aufweist, der jedoch gleich hoch ist wie die übrigen Interconnect-Bausteine (130), oder um weniger als 30 µm in der Höhe von den übrigen Interconnect-Bausteinen (130) abweicht.

14. Dreidimensional-integriertes Multi-IC System (100) nach einem der Ansprüche 1 bis 13,
wobei einer oder mehrere der aktiven IC-Bausteine (120) in Form von ungehäusten Halbleiter-Bausteinen, sogenannten bare dies, oder in Form von Chiplets ausgestaltet ist / sind.

15. Dreidimensional-integriertes Multi-IC System (100) nach einem der Ansprüche 1 bis 14,
wobei zwei, auf demselben Substrat (111) benachbart angeordnete, aktive IC-Bausteine (120) in einem Abstand von 10 µm bis 300 µm zueinander angeordnet sind.
